# EUROPEAN PATENT SPECIFICATION

(11) **EP 0 902 294 B1**
(45) Date of publication and mention of the grant of the patent: **30.11.2005**
(21) Application number: 97115644.3
(22) Date of filing: 09.09.1997
(51) Int. Cl.: G01R 19/165

(54) **A voltage monitoring circuit**
Schaltungsanordnung zur Spannungsüberwachung
Circuit de surveillance d'une tension

(43) Date of publication of application: 17.03.1999
(73) Proprietor: TEXAS INSTRUMENTS DEUTSCHLAND GMBH, 85356 Freising (DE)
(72) Inventor: Götz, Laszlo, 85356 Freising (DE)
(74) Representative: Degwert, Hartmut

(56) References cited:
- EP-A- 0 127 139
- EP-A- 0 678 751
- US-A- 5 440 254
- US-A- 5 617 285
- PATENT ABSTRACTS OF JAPAN vol. 016, no. 386 (P-1404), 18 August 1992 & JP 04 125470 A (FUJITSU LTD), 24 April 1992,

## Description

The invention generally relates to a voltage monitoring circuit and more especially to a circuit for monitoring the supply voltage of battery powered microprocessors.

In digital systems such as microcomputers and microprocessors it is important for them only to be put in an active condition, when their supply voltage is at its desired value. Any drop or collapse of the supply voltage may lead to faulty operation of such systems. Consequently as a rule they generally comprise a circuit for monitoring the value of the supply voltage.

In recent times portable systems, which are powered from a battery, are coming to play a more and more important role. In such equipment the voltage monitoring circuits monitor the supply voltage of the microprocessors.

One example for such a voltage monitoring circuit as so far employed is provided by technical information published by Texas Instruments of 28.4.1995 entitled "TLC77XX Series of BiCMOS SUPPLY VOLTAGE SUPERVISORS", pages 9 ff.

In this circuit the comparator is utilized, which at one reference input receives voltage from a reference voltage source as a desired voltage. The reference voltage source, which in this case comprises a band gap reference, is constantly powered for the production of the reference voltage Vref. The voltage Vcc to be monitored is so split up by an ohmic voltage divider consisting of two resistors that at one of the two resistors there is a voltage drop with a value generally equal to the reference voltage, if said voltage Vcc to be monitored is at its full level. In fact, if the voltage Vcc to be monitored is at its full level, it will exceed the reference voltage by a certain safety tolerance threshold. The voltage present at the tapping point of the voltage divider will then be applied to the signal input of the comparator as the actual voltage. If the actual voltage is smaller than the desired voltage, the comparator will provide a warning signal.

US 5 440 254 discloses a circuit for monitoring a supply voltage. It uses a resistive voltage divider, whose operation can be disabled by switches.

A disadvantage of the voltage monitoring circuits described is that owing to constant operation of the reference voltage source and the losses occurring in the resistors of the ohmic voltage divider, it requires a relatively large amount of energy.

Accordingly one object of the invention is to provide a voltage monitoring circuit of the type initially mentioned avoiding the disadvantage of the initially described prior art while nevertheless reacting reliably to changes in the supply voltage.

In the voltage monitoring circuit of the invention during periods of time, in which in the comparators the actual voltage is larger than the desired voltage, the significant current loads are cut off from the supply voltage so that they are unable to consume any energy. In such periods of time the comparators compare voltage stored in capacitors. In order to for such voltage always to present a true picture of the voltage which is in fact to be monitored, the second comparator produces - owing to the intentionally produced leak current through the capacitor connected with the its signal input - a control signal, which serves to refresh the desired and actual voltages present in the capacitors.

The result is consequently a voltage monitoring circuit with a low energy requirement and which reliably reacts to changes in the supply voltage for a load, for example for a microprocessor.

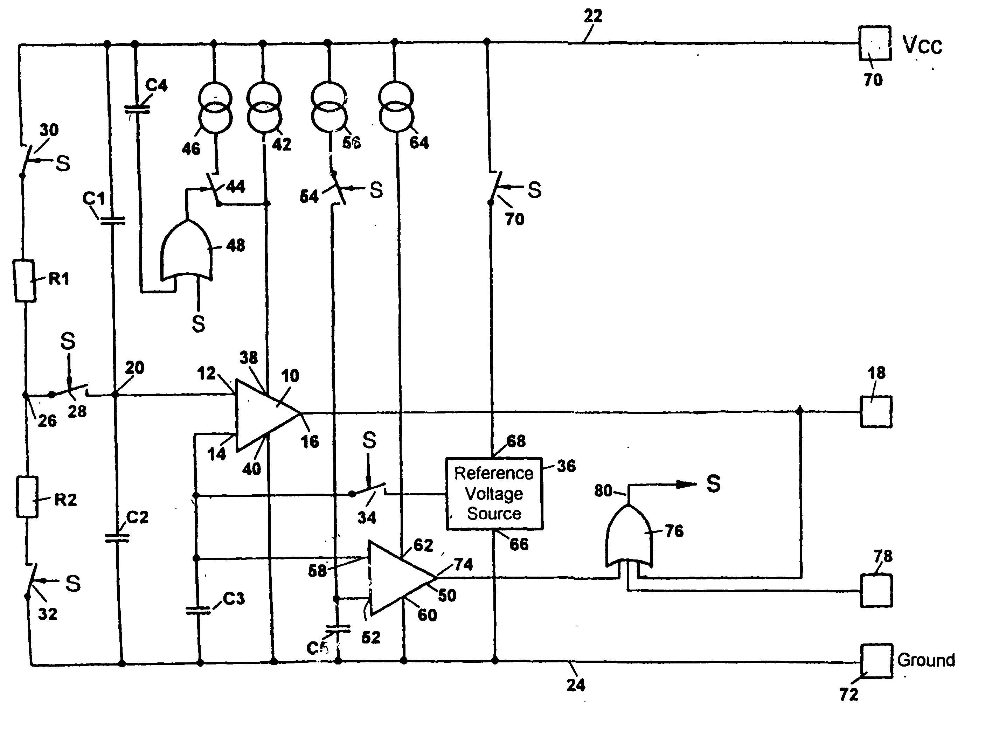

The invention will now be explained in detail with reference to one embodiment and to the accompanying drawing in which:- the single figure shows a circuit diagram of one embodiment of the voltage monitoring circuit in accordance with the present invention.

The voltage monitoring illustrated in the drawing comprises a first comparator 10, which possesses a signal input 12 and a reference input 14. The output 16 of the comparator 10 is connected with the output terminal 18. As will be seen, the signal input 12 of the comparator 10 is connected with the tapping point 20 of a capacitive voltage divider comprising a capacit C1 and a capacitor C2 connected with it in series, such capacitor C2 being placed between the supply voltage line 22 and the ground line 24. Parallel to such capacitive voltage divider there is, also between the supply voltage line 22 and the ground line 24, an ohmic voltage divider comprising a resistor R1 and a resistor R2 connected in series therewith. The tapping point 26 of this ohmic voltage divider is able to be connected by way of a switch 28 with the tapping point 20 of the capacitive voltage divider and accordingly also with the signal input 12 of the comparator 10. Furthermore a switch 30 and, respectively, 32 is connected in series both with the resistor R1 and also with the resistor R2 so that on opening such switches the resistors R1 and R2 are cut off from the supply voltage line 22 and, respectively, from the ground line 24.

The reference input 14 of the comparator 10 is able to be connected via a switch 34 with the output of a reference voltage source 36. Moreover, between the reference input 14 and the ground line 24 there is a further capacitor C3.

Via supply inputs 38 and 40 the comparator 10 is on the one hand connected with the ground line 24 and on the other hand via a current source 42 it is connected with the supply voltage line 22. By closing a switch 44 a further current source 46 may be placed in parallel with the current source 42 so that the comparator 10 may in case of need be supplied with a higher supply current. The switch 44 is controlled by the output signal of an OR gate circuit 48, such gate being connected at one input via a capacitor C4 with the supply voltage line 22, whereas its second input may be supplied with a switching signal S yet to be explained.

The voltage monitoring circuit furthermore includes a second comparator 50, whose signal input 52 is able to be connected via a switch 54 and a current source 56 with the supply voltage line 22. Furthermore between the signal input 52 of the comparator 50 and the ground line 24 there is a further capacitor C5. The reference input 58 of the comparator 50 is connected with the reference input 14 of the comparator 10.

Just like the comparator 10, the comparator 50 possesses two supply terminals (60 and 62), which are in this case connected with the ground line 24 and, via a current source 64, with the supply voltage line 22.

The reference voltage source 36 possesses two supply terminals 66 and 68, which are connected with the ground line 24 and, respectively, via a switch 70 with the supply voltage line 22.

The supply voltage Vcc is applied to the supply voltage line 22 via a terminal 70. Ground potential is applied to the ground line 24 via a terminal 72.

The output 74 of the comparator 50 is connected with one output of an OR gate circuit 76 having a further input, connected with the output 16 of the comparator 10, and an input connected with an input terminal 78. The output 80 of the OR gate circuit 76 is connected with the control terminals of the switches 28, 30, 32, 34, 54 and 70 and with one input of the OR gate circuit 48.

The voltage monitoring circuit described so far functions as follows:

Let it be assumed that the circuit described is to be employed to monitor a voltage Vcc of 5 V, which is applied by battery via the terminal 70 to the supply voltage line 22. When the circuits are not yet in operation, all switches are opened and all capacitors are discharged.

On putting the voltage monitoring circuit into operation a switch-on pulse is applied to the terminal 78 with the consequence that at its output 80 the OR gate circuit 76 applies this switch-on pulse in the form of the switching S to the switches so that same are closed. The consequence of this is that the reference voltage source 36 starts operating and via the closed switch 34 applies a reference voltage both to the reference input 14 of the comparator 10 and also to the reference input 58 of the comparator 50. Owing to the closed state of the switches 28, 30 and 32 a voltage will be present at the signal input 12 of the comparator 10 which is dependent on the ratio between the resistors R1 and R2 and on the ratio of the capacitors C1 and C2. The resistors R1 and R2 and the capacitors C1 and C2 respectively have such a size that the there is the same voltage at the tapping points of the two voltage dividers. This assumes that the resistors and the capacitors divide the applied supply voltage with the same ratio in each case.

Since the switch 54 is also closed, the voltage present at the voltage line 22 will also become established at the signal line 52 of the comparator 50.

After the termination of the start pulse the switching signal S at the output 80 of the OR gate circuit 76 will also terminate so that all switches in the voltage monitoring circuit described are opened. The result of this is that the voltage divider comprising the resistors R1 and R2 is cut off from the supply voltage, whereas the tapping point 26 of such voltage divider is cut off from the signal line 12 of the comparator 10. In this condition this signal input 12 will be getting the voltage present at the tapping point 20 of the capacitive voltage divider made up of the capacitors C1 and C2. Owing to the opening of the switch 34 the reference voltage source 36 is cut off from the reference inputs of the two comparators 10 and 50 with the result that such reference inputs will no longer be getting the output voltage of the reference voltage source 36 but rather the voltage stored in the capacitor C3.

After opening the said switches the comparator 10 compares the voltage present at the tapping point 20 of the capacitive voltage divider C1 and C2 with the voltage present at the reference input 14 and stored in the capacitor C3. The comparator 50 compares the voltage present at its reference input 58 with the voltage stored in the capacitor C5.

Should the voltage Vcc to be monitored not have risen to its desired value after opening of the switches, the comparator 10 will then detect that the voltage present at its signal input 12 is smaller than the voltage present at its reference input 14. The consequence of this is that at the output 16 of the comparator 10 a signal with the value "1" will appear, same being supplied on the one hand to the output terminal 18 as a warning signal and on the other hand to the OR gate circuit 76 as a control signal, this meaning that the switching signal 5 is issued at the output 80 of this OR gate circuit. The switching signal S leads to a renewed closing of the switches so that the voltages are refreshed at the inputs of the two comparators 10 and 50. The signal with the of value of "1" at the output 16 of the comparator 10 dwells until the voltage value at the signal input 12 of the comparator 10 is larger than the voltage value at the reference input 14. As soon as this takes place the control signal at the output 16 of the comparator 10 will assume the value of "0" with the result that following this the switching signal S will no longer appear at the output 80 of the OR gate circuit 76. The said switches then all change over into the opened state.

The comparison of the voltage present at the tapping point 20 and accordingly at the signal input 12 of the comparator with the voltage at its reference input 14 renders possible effective monitoring of the voltage at the supply voltage line 22. Owing to leak currents there is in fact a change in the voltage at the tapping point 20 so that it will no longer bear the same ratio to be supply voltage as set by the ratio of the capacitors C1 and also of the resistors R1 and R2.

In the above described voltage monitoring circuit measures are provided to ensure that the voltage at the tapping point 20 is at all times so refreshed that it bears the right ratio or relationship to the monitored supply voltage Vcc. It behaves as if it directly monitors the voltage Vcc and not a voltage derived from it and stored in the capacitors. The control signal for causing this refresh operation to take place is produced by the comparator 50.

Like the comparator 10 The comparator 50 compares the voltage present at its signal input 52 with the voltage at its reference input 58, these Lwo voltages being stored in the capacitor C5 and, respectively, in the capacitor C3. The capacitor C5 is a capacitor with an extremely small size in comparison with the capacitor C3 (1/10 or even 1/100 of capacitance value of the capacitor C3) so that as compared with the other capacitors employed in the circuit it has a high leak current. The consequence of this is that the voltage stored in it and accordingly applied to the signal line 52 of the comparator 50 falls significantly more rapidly, owing to this high leak current, than the voltages in the other capacitors. As soon as the actual voltage at the signal input 52 of the comparator 50 becomes smaller than the desired voltage at the reference input 58 the comparator 50 provides a control signal which is applied by the OR gate circuit 76 as a switching signal S to the switches 28, 30, 32, 34, 54 and 70 and via the OR gate circuit 48 to the switch 44 as well, this meaning that such switches are closed. Owing to the closing of the switches, by way of the ohmic voltage divider R1 and R2 the desired voltage is re-applied to the signal input 12 of the comparator 10 and the reference voltage is applied to the reference inputs 14 and 58 of the comparators 10 and, respectively, 50. Furthermore in the capacitor C5 the supply voltage Vcc is restored.

So far we have assumed that the supply voltage Vcc has not changed and has maintained the desired value of 5 V. After the refresh operation the signal input 52 of the comparator 50 will again receive a voltage which is larger than the reference voltage at the reference input 58 so that the comparator 50 will no longer supply the control signal. In the example being described this means that the output signal of the comparator 50 will resume the signal value of "0". Accordingly the switching signal S also will return to the value of "0" so that the switches will change back to the opened condition. We will now have the same condition in which the comparators compare the voltage stored in the capacitors C1, C2 and, respectively, C3 and C5. Since in such condition neither the voltage divider R1 and R2 nor the reference voltage source 36 are connected with the supply voltage Vcc, the current consumption of the voltage monitoring is drastically reduced in this period of time. In practice it has in fact been found that it is particularly a high accuracy reference voltage source which requires a relatively high operating current in comparison with the other components employed in the circuit so that switching off of the reference voltage source leads to a significant reduction in current consumption. Furthermore the switching off of the ohmic voltage divider R1 and R2 contributes to such current reduction.

It is now assumed that after the last production of the switching signal S and the closing of the switches resulting therefrom the supply voltage Vcc will have fallen to a value, which is below a tolerance value which is still acceptable. This value of the supply voltage Vcc must therefore lead to the production of the warning signal at the output 16 of the comparator 10. The fall in the supply voltage Vcc means that a lower voltage value will also occur at the tapping point 20 of the capacitive voltage divider and also at the signal input 12 of the comparator 10, such value being, as being assumed, smaller than the reference voltage value at the reference input 14. At its output 16 the comparator 10 accordingly provides a warning signal with the value of "1", which via the terminal 18 may be supplied to the device having the described voltage monitoring circuit, and there it may cause desired reactions. For instance a user may be informed by means of a display device that the battery of the device must be renewed. The warning signal could for example however also cause important data to be saved in the device and reset a microprocessor present in the device to a predetermined initial state.

The above described behavior may be assumed in the case of a slow drift of the voltage Vcc to be monitored. In order to ensure that the voltage monitoring circuit may also respond to rapid changes in the supply voltage with the least possible delay, an additional current source 46 is provided, which can be placed in circuit across the switch 44 parallel to the current source 42. Closing of the switch is on the one hand effected by the switching signal S during normal operation. Then the comparator 10, when it is supplied with increased current, reacts more rapidly to a change in the voltage at its signal input 12. The control signal for closing the switch 44 is then provided as well by the OR gate circuit 48, when via the capacitor C4 a pulse passes to such OR gate circuit 48, this always occurring, when an extremely rapid change in the supply voltage Vcc takes place. This rapid change in voltage passes via the capacitor C1 to the signal input 12 as well of the comparator 10. For those cases in which extremely rapid reaction of the comparator 10 is mandatory, the parallel arrangement of the current source 46 to the current source 42 ensures an increase in the supply flow of the comparator so that the comparator may react in accordance with requirements.

In the above described voltage monitoring circuit the reference voltage source preferably takes the form of a band gap reference then providing a highly constant output voltage of 1.2 V. In a specific case it may be assumed that the supply voltage Vcc to be monitored will have a value of 5 V and that a fall to 4,85 V should not trip the comparator 10 and should not lead to the production of the warning signal. It is only when the voltage drops to below 4.85 V that the warning signal is to be produced. If in this example the resistor R1 has a value of 3.65 kΩ and the resistor R2 has a value of 1.2 kΩ, there will be, if the supply voltage Vcc has value of 5 V, at the signal input 12 of the comparator 10 a voltage of 1.237 V. As soon as the supply voltage Vcc sinks to below 4,85 V, a voltage value of below 1.2 V will be reached at the signal input, this value being lower than the reference voltage from the reference voltage source 36 of 1.2 V. This leads to a response of the comparator 10 and to the production of the warning signal at its output. The capacitors C1 and C2 divide, as already mentioned, the voltage Vcc in the same ratio as the resistors R1 and R2, the capacitance values of such capacitors being able to be selected in accordance with possibilities and requirements.

The entire voltage monitoring circuit may be designed in the form of an integrated circuit, it being accommodated with a low space requirement directly on the semiconductor chip of a microprocessor for monitoring its voltage supply voltage.

## Claims

1. A voltage monitoring circuit comprising;
a first comparator (10) having a reference input (14) for receiving a first potential, said first potential being generated by a reference potential source (36) fed with a potential (Vcc) to be monitored, said first comparator (10) receiving an al potential derived from the potential (Vcc) to be monitored at a signal input (12), said actual potential being derived from a tapping point (26) of an ohmic voltage divider (R1,R2), the first comparator generating a warning signal when the actual potential at the signal input (12) is less than the desired potential at the reference input (14); **characterized by**
a capacitive voltage divider (C1,C2) connected in parallel with the ohmic voltage divider (R1,R2), said capacitive voltage divider (C1,C2) dividing said potential (Vcc) to be monitored at a tapping point (20) coupled to the signal input of the first comparator (10) and to the tapping point (26) of the ohmic voltage divider (R1,R2), said ohmic voltage divider (R1,R2) having the same ratio as the capacitive voltage divider (C1,C2);
a second comparator (50) for receiving the first potential as a desired potential at one reference input (58) and the potential (Vcc) to be monitored as the actual potential at a second signal input (52), the second comparator (50) producing a control signal when the actual potential at the second signal input (52) becomes less than the desired potential at the reference input (58) thereof;
a first storage capacitor (C3) with one of its plates coupled to the reference input (14) of the first comparator (10) and to the reference input (58) of the second comparator (50);
a second storage capacitor (C5) coupled to the second signal input (52) of the second comparator (50), said second storage capacitor (C5) being smaller than the first storage capacitor (C3) and the capacitors (C1,C2) of the capacitive voltage divider such that the leakage current thereof is increased and the potential stored in the second storage capacitor (C5) drops more rapidly than potentials stored in the remaining capacitors (C1, C2, C3);
and wherein the ohmic voltage divider (R1, R2) is arranged to be isolated from the potential (Vcc) to be monitored by means of controlled switches (30,32), and from the signal input (12) of the first comparator (10) and the tapping point (20) of the capacitive voltage divider (C1, C2) by means of a controlled switch (28);
wherein the reference source (36) is arranged to be potential isolated from the reference inputs of the first comparator (10) and the second comparator (50), and from the potential (Vcc) to be monitored, by means of controlled switches (34, 70);
wherein the signal input (52) of the second comparator is arranged to be isolated from the potential (Vcc) to be monitored by means of a controlled switch (54); and
wherein a switching signal (S) derived from a control signal from the second comparator (50) or a switching signal (S) derived from the warning signal from the first comparator (10) is supplied to the controlled switches (28, 30, 32, 34, 54, 70) for actuating said switches.

2. The circuit as claimed in Claim 1, wherein the reference potential source (36) is a band space reference.

3. The circuit as claimed in Claim 1 or Claim 2, with an additional current source (46) for coupling to a current supply input of the first comparator (10) via a controlled switch (44), said switch being actuable to a closed state by the switching signal (S) or by a further control signal produced by a rapid drop in the potential (Vcc) to be monitored.

4. The circuit as claimed in Claim 3, wherein a further control signal is produced by a capacitor (C4) connected to the voltage potential (Vcc) to be monitored.

5. The circuit as claimed in any preceding claim, wherein the circuit is provided in the form of an integrated circuit.

## Patentansprüche

1. Spannungsüberwachungsschaltung mit:
einem ersten Komparator (10), der an einem Referenzeingang (14) eine erste Spannung empfängt, die von einer durch eine zu überwachende Spannung (Vcc) gespeisten Referenzspannungsquelle (36) erzeugt wird, und der an einem Signaleingang (12) eine von der zu überwachenden Spannung (Vcc) abgeleitete Istspannung empfängt, die von einem Abgriff (26) eines ohmschen Spannungsteilers (R1, R2) abgeleitet ist, wobei der erste Komparator ein Warnsignal abgibt, wenn die Istspannung am Signaleingang (12) kleiner als die Sollspannung am Referenzeingang (14) ist, **gekennzeichnet durch**
einen kapazitiven Spannungsteiler (C1, C2), der parallel zum ohmschen Spannungsteiler (R1, R2) geschaltet ist und die zu überwachende Spannung (Vcc) an einem mit dem Signaleingang des ersten Komparators (10) und dem Abgriff (26) des ohmschen Spannungsteilers (R1, R2) verbundenen Abgriff (20) aufteilt, wobei der ohmsche Spannungsteiler (R1, R2) das gleiche Verhältnis wie der kapazitive Spannungsteiler (C1, C2) hat,
einen zweiten Komparator (50), der an einem Referenzeingang (58) als Sollspannung die erste Spannung und an einem zweiten Signaleingang (52) als Istspannung die zu überwachende Spannung (Vcc) empfängt, wobei der zweite Komparator (50) ein Steuersignal abgibt, wenn die Istspannung am zweiten Signaleingang (52) kleiner als die Sollspannung an seinem Referenzeingang (58) wird,
einen ersten Speicherkondensator (C3), der mit einer seiner Platten mit dem Referenzeingang (14) des ersten Komparators (10) und dem Referenzeingang (58) des zweiten Komparators (50) verbunden ist,
einen zweiten Speicherkondensator (C5), der mit dem zweiten Signaleingang (52) des zweiten Komparators (50) verbunden ist und kleiner ausgeführt ist als der erste Speicherkondensator (C3) und die Kondensatoren (C1, C2) des kapazitiven Spannungsteilers, so dass sich sein Leckstrom erhöht und die am zweiten Speicherkondensator (C5) gespeicherte Spannung schneller absinkt als an den übrigen Kondensatoren (C1, C2, C3) gespeicherte Spannungen,
wobei der ohmsche Spannungsteiler (R1, R2) mittels gesteuerter Schalter (30, 32) von der zu überwachenden Spannung (Vcc) und mittels eines gesteuerten Schalters (28) vom Signaleingang (12) des ersten Komparators (10) sowie vom Abgriff (20) des kapazitiven Spannungsteilers (C1, C2) abtrennbar ist,
die Referenzspannungsquelle (36) mittels gesteuerter Schalter (34, 70) von den Referenzeingängen des ersten Komparators (10) und des zweiten Komparators (50) sowie von der zu überwachenden Spannung (Vcc) abtrennbar ist,
der Signaleingang (52) des zweiten Komparators mittels eines gesteuerten Schalters (54) von der zu überwachenden Spannung (Vcc) abtrennbar ist, und
ein von einem Steuersignal aus dem zweiten Komparator (50) oder ein vom Warnsignal aus dem ersten Komparator (10) abgeleitetes Schaltsignal (S) den gesteuerten Schaltern (28, 30, 32, 34, 54, 70) zur Betätigung dieser Schalter zugeführt wird.

2. Schaltung nach Anspruch 1, bei der die Referenzspannungsquelle (36) eine Bandabstands-Referenz ist.

3. Schaltung nach Anspruch 1 oder Anspruch 2, mit einer Zusatzstromquelle (46), die über einen gesteuerten Schalter (44) an einen Stromversorgungseingang des ersten Komparators (10) anschließbar ist, wobei der Schalter (44) durch das Schaltsignal (S) oder durch ein durch ein schnelles Absinken der zu überwachenden Spannung (Vcc) erzeugtes weiteres Steuersignal in einen geschlossenen Zustand versetzbar ist.

4. Schaltung nach Anspruch 3, bei der ein weiteres Steuersignal durch einen mit der zu überwachenden Spannung (Vcc) verbundenen Kondensator (C4) erzeugt wird.

5. Schaltung nach einem vorhergehenden Anspruch, bei der sie in Form einer integrierten Schaltung vorgesehen ist.

## Revendications

1. Circuit de surveillance de tension comprenant ;
un premier comparateur (10) ayant une entrée de référence (14) pour recevoir un premier potentiel, ledit premier potentiel étant généré par une source de potentiel de référence (36) alimentée par un potentiel (Vcc) devant être surveillé, ledit premier comparateur (10) recevant un potentiel réel dérivé du potentiel (Vcc) devant être surveillé à une entrée de signal (12), ledit potentiel réel étant dérivé d'un point de prise (26) d'un diviseur de tension ohmique (R1, R2), le premier comparateur générant un signal d'avertissement lorsque le potentiel réel à l'entrée de signal (12) est inférieur au potentiel souhaité à l'entrée de référence (14) ;
**caractérisé par**
un diviseur de tension capacitif (C1, C2) connecté parallèlement au diviseur de tension ohmique (R1, R2), ledit diviseur de tension capacitif (C1, C2) divisant ledit potentiel (Vcc) devant être surveillé à un point de prise (20) couplé à l'entrée de signal du premier comparateur (10) et au point de prise (26) du diviseur de tension ohmique (R1, R2), ledit diviseur de tension ohmique (R1, R2) ayant le même rapport que le diviseur de tension capacitif (C1, C2) ;
un second comparateur (50) pour recevoir le premier potentiel comme potentiel souhaité à une entrée de référence (58) et le potentiel (Vcc) devant être surveillé comme potentiel réel à une seconde entrée de signal (52), le second comparateur (50) produisant un signal de commande lorsque le potentiel réel à la seconde entrée de signal (52) devient inférieur au potentiel souhaité à l'entrée de référence (58) de ce dernier ;
un premier condensateur de stockage (C3) avec l'une de ses plaques couplée à l'entrée de référence (14) du premier comparateur (10) et à l'entrée de référence (58) du second comparateur (50) ;
un second condensateur de stockage (C5) couplé à la seconde entrée de signal (52) du second comparateur (50), ledit second condensateur de stockage (C5) étant plus petit que le premier condensateur de stockage (C3) et les condensateurs (C1, C2) du diviseur de tension capacitif de sorte que le courant de fuite de ce dernier est augmenté et le potentiel stocké dans le second condensateur de stockage (C5) chute plus rapidement que les potentiels stockés dans le reste des condensateurs (C1, C2, C3) ;
et dans lequel le diviseur de tension ohmique (R1, R2) est agencé pour être isolé du potentiel (Vcc) devant être surveillé au moyen d'interrupteurs commandés (30, 32), et de l'entrée de signal (12) du premier comparateur (10) et du point de prise (20) du diviseur de tension capacitif (C1, C2) au moyen d'un interrupteur commandé (28) ;
dans lequel la source de potentiel de référence (36) est agencée pour être isolée des entrées de référence du premier comparateur (10) et du second comparateur (50), et du potentiel (Vcc) devant être surveillé au moyen d'interrupteurs commandés (34, 70) ;
dans lequel l'entrée de signal (52) du second comparateur est agencée pour être isolée du potentiel (Vcc) devant être surveillé au moyen d'un interrupteur commandé (54) ; et
dans lequel un signal de commutation (S) dérivé d'un signal de commande du second comparateur (50) ou un signal de commutation (S) dérivé du signal d'avertissement du premier comparateur (10) est fourni aux interrupteurs commandés (28, 30, 32, 34, 54, 70) pour actionner lesdits interrupteurs.

2. Circuit selon la revendication 1, dans lequel la source de potentiel de référence (36) est une référence d'espace de bande.

3. Circuit selon la revendication 1 ou la revendication 2, avec une source de courant additionnelle (46) pour le couplage à une entrée d'alimentation en courant du premier comparateur (10) via un interrupteur commandé (44), ledit interrupteur pouvant être actionné dans un état fermé par le signal de commutation (S) ou par un signal de commande supplémentaire produit par une chute rapide du potentiel (Vcc) devant être surveillé.

4. Circuit selon la revendication 3, dans lequel un signal de commande supplémentaire est produit par un condensateur (C4) connecté au potentiel (Vcc) de tension (Vcc) devant être surveillé.

5. Circuit selon l'une quelconque des revendications précédentes, dans lequel le circuit est fourni sous forme de circuit intégré.
